Europäisches Patentamt

European Patent Office

Office européen des brevets

(11) Publication number: **0 246 781**
A2

(12) **EUROPEAN PATENT APPLICATION**

(21) Application number: **87304036.4**

(22) Date of filing: **06.05.87**

(51) Int. Cl.³: **G 01 R 33/02**

(30) Priority: **21.05.86 GB 8612359**

(43) Date of publication of application:
**25.11.87 Bulletin 87/48**

(84) Designated Contracting States:
**FR GB IT**

(71) Applicant: **GEC AVIONICS LIMITED**
**Airport Works**
**Rochester Kent ME1 2XX(GB)**

(72) Inventor: **Oetzmann, Emerson Hardy**
**The Elms**
**Hinxhill Ashford Kent(GB)**

(74) Representative: **Pope, Michael Bertram Wingate**
**Central Patent Department Wembley Office The General**
**Electric Company, p.l.c. Hirst Research Centre East Lane**
**Wembley Middlesex HA9 7PP(GB)**

(54) **Magnetic field direction indicating devices.**

(57) A magnetic field direction indicating device comprising two magnetic sensors (1, 3) disposed at right angles. Each sensor (1, 3) has a dipole directional characteristic (13, 15) and is subjected to a sinusoidal biassing magnetic field. The two magnetic fields are in time quadrature relationship. The signals output by the magnetic sensors (1, 3) are utilised to produce a signal having a phase indicative of the direction of the magnetic field in the region of the device.

EP 0 246 781 A2

./...

Croydon Printing Company Ltd

Fig.2.

-1-

FAM/2923 $\epsilon \theta \subset$

## Magnetic Field Direction Indicating Devices

This invention relates to devices for indicating the direction of a magnetic field.

It is an object of the present invention to provide such a device having no moving parts.

According to the present invention a device for indicating the direction of an applied magnetic field comprises: first and second magnetic sensors each exhibiting a dipole directional characteristic and disposed with their maximum sensitivity directions at right angles; means for subjecting said sensors to respective sinusoidal biassing magnetic fields in time quadrature relationship so as to produce sensor output signals respectively of the form:

$$\cos \theta \cos wt$$
and $$\sin \theta \cos \left(wt \pm \frac{\pi}{2}\right)$$

where $\theta$ is the angle between the maximum sensitivity direction of one of the sensors and the direction of said applied magnetic field and $\underline{w}$ is the angular frequency of the biassing fields; and means for adding or subtracting said output signals to provide a device output whose phase relative to the phase of a said biassing field indicates the direction of said applied magnetic field.

One device in accordance with the invention will now be described by way of example with reference to the accompanying drawings of which:-

Figure 1 shows a plan view of two magnetic sensors forming part of the device and their associated directional characteristics; and

Figure 2 is a schematic diagram of the whole device.

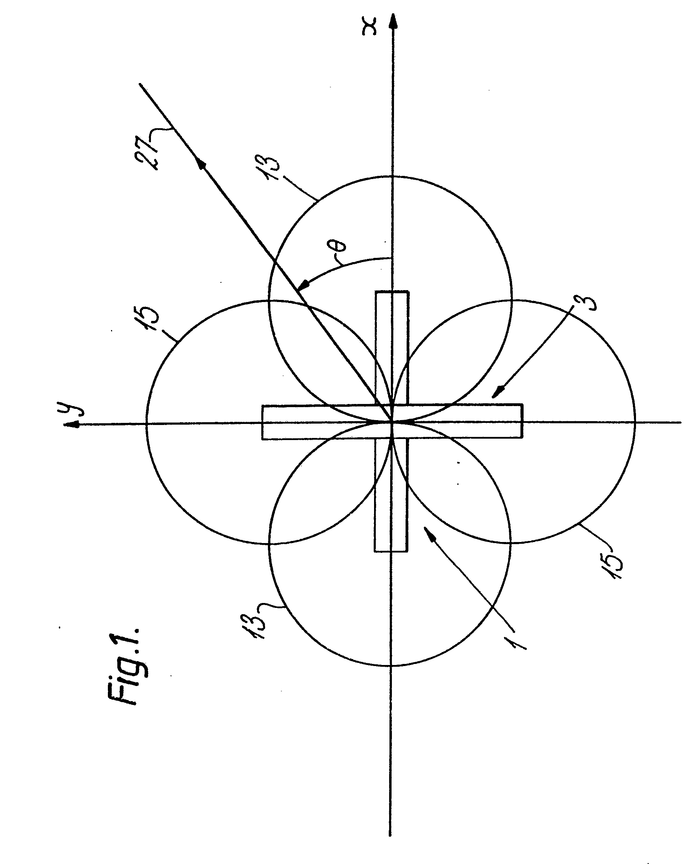

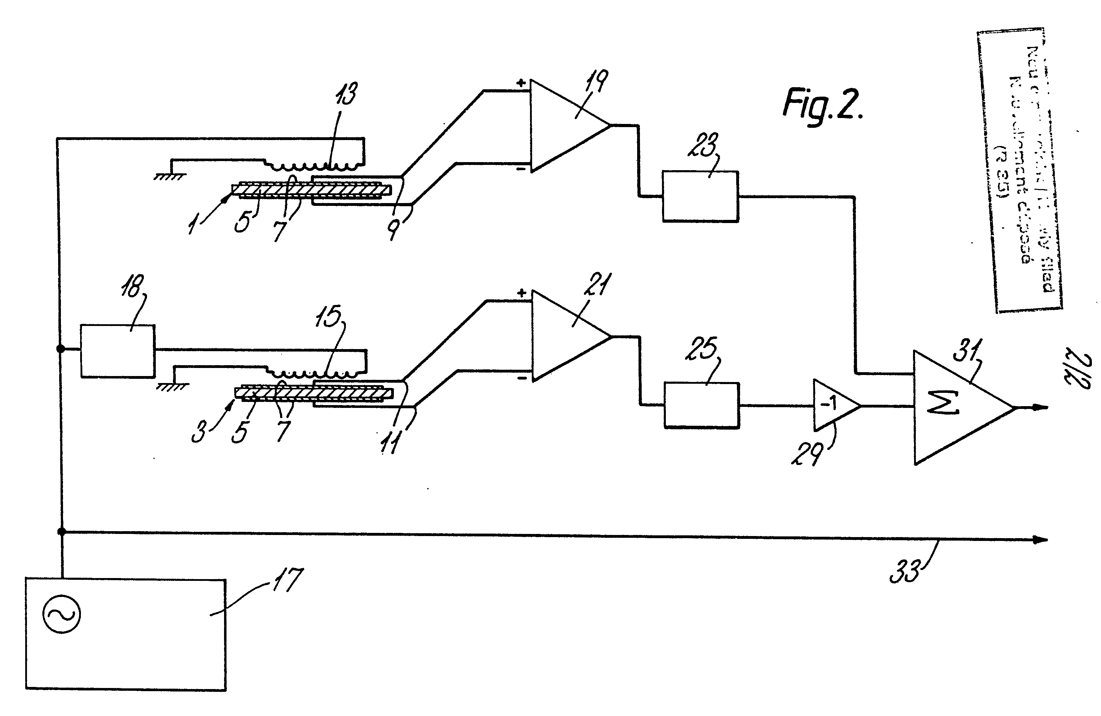

Referring to Figures 1 and 2 the device includes two magnetic sensors 1, 3 of a kind forming the subject of United Kingdom patent application No. 8705449, the sensor being shown in Figure 1 schematically only. Each of the sensors 1, 3 comprises a rectangular strip of piezoelectric material 5 sandwiched between two rectangular strips of electrically conductive magnetostrictive material 7 having a smaller width than the strip 5. The strips 7 are of the same length as the strip 5 and are positioned centrally on the opposite main surface of the strip 5, with their narrow ends in register with the narrower end of the strip 5. The strip 5 is piezoelectrically active so that when subject to compression or tension in a direction parallel to its main surfaces it will generate a potential difference between its main surfaces. The two strips 7 also serve as electrodes of the sensors 1, 3.

As shown in plan view in Figure 1 the two magnetic sensors 1, 3 are physically arranged so that their lengths are perpendicular.

When the magnetic sensor 1 or 3 is subjected to a magnetic field directed, or having a component, parallel to its length the strips 7 will expand in the direction of the applied field or in the direction of the component of the applied field and consequently stretch the strips 5 in the same direction. A potential difference is consequently generated between the strips 7 whose value is representative of the strength of the applied field in the direction parallel to the length of the sensor 1 or 3.

Referring to Figure 2, this potential difference may thus be applied to an electric circuit described below via the leads 9, 11 respectively of the sensors 1, 3.

It will be appreciated that the sensitivity of each of the two sensors 1, 3 will depend on the direction of the applied field, each sensor 1, 3 exhibiting maximum sensitivity in the direction of its length and sensitivity of virtually zero in the direction of its width. Thus the sensors 1, 3 exhibit dipole directional characteristics 13, 15 respectively as shown in Figure 1.

Due to the physical arrangement of the two magnetic sensors 1, 3, when the magnetic sensor 1 is exhibiting maximum sensitivity, for example when the applied magnetic field acts along the x axis as shown in Figure 1, the magnetic sensor 3 will exhibit virtually zero sensitivity and vice versa. Thus the dipole characteristics 13, 15 are perpendicular to each other as shown in Figure 1.

Referring to Figure 2, as described in United Kingdom Patent Application No. 8705449, each of the magnetic sensors 1, 3 is subjected to an alternating magnetic biassing field produced by the alternating current fed by the reference generator 17 to coils 13, 15 wound around and along the lengths of the sensors 1, 3 respectively.

The phase of the alternating current fed to the sensor 3 is arranged to be out of phase by $\pi/2$ with the alternating current fed to the sensor 1. This is effected by the presence of the $\pi/2$ phase shifter 18.

The voltages between the leads 9 and between the leads 11 are fed respectively via differential amplifiers 19, 21 to bandpass filters 23, 25. The bandpass filters 23, 25 are designed so that their outputs comprise double sideband suppressed carrier versions of carriers of the frequency of the reference frequency generator 17, amplitude modulated by the applied field in the region of the magnetic sensors 1, 3.

For use as a magnetic compass to determine the direction of the magnetic meridian the sensors 1, 3 are placed with their lengths horizontal.

The outputs of the bandpass filters 23, 25 are of the form:

$$V_1 = H_0 \cos \theta \cos wt \qquad (1)$$

for the magnetic sensor 1 and

$$V_2 = H_0 \sin \theta \sin wt \qquad (2)$$

for the magnetic sensor 3, where $H_0$ is the horizontal component of the earth's magnetic field, $\theta$ is the angle between the length of the magnetic sensor 1 and the direction of magnetic north 27 as shown in Figure 1, $w$ is the angular frequency of the biassing field and $t$ is time. It should be noted that the cosine functions occur in equation (1) and sine functions occur in equation (2) because of the perpendicular relationship to each other of the dipole characteristics 13, 15 shown in Figure 1 and the $\pi/2$ phase shift in the alternating current fed to the sensors 1, 3 respectively as shown in Figure 2.

The output $V_2$ of the bandpass filter 25 is fed via an inverter 29 to one input of a summing amplifier 31, the output $V_1$ of the bandpass filter 23 being fed directly to the other input. The output of the summing amplifier 31 is therefore:

$$V_1 - V_2 = H_0 \cos \theta \cos wt - H_0 \sin \theta \sin wt$$
$$V_1 - V_2 = H_0 (\cos \theta \cos wt - \sin \theta \sin wt)$$
$$V_1 - V_2 = H_0 \cos (\theta + wt) \tag{3}$$

From equation (3) it can be seen that the output of the summing amplifier 31 has an amplitude $H_0$ proportional to the strength of the horizontal component of the earth's magnetic field in the region of the device and a phase shift $\theta$ with respect to the phase of the biassing alternating current applied to the sensor 1 equal to the bearing of magnetic north from the length of the magnetic sensor 1. The phase shift 0 can be detected by applying the output of the summing amplifier 31 and a phase reference signal 33, obtained from the reference frequency generator 17, to a phase detector (not shown). Alternatively, the phase shift $\theta$ and the amplitude $H_0$ may be detected by applying the output of the summing amplifier 31 and a reference signal 33, obtained from the reference frequency generator 17, to a phase and gain meter (not shown).

It will be appreciated that instead of subtracting the outputs $V_1$ and $V_2$ one from the other, the signals $V_1$ and $V_2$ may be added to provide an output

$$V_1 + V_2 = H_0 \cos (\theta - wt),$$

which output also has an amplitude $H_0$ and a phase shift $\theta$ equal to the bearing of magnetic north.

In a modification of the device of Figure 2, the two bandpass filters 23, 25 are replaced by a single bandpass filter via which the output of the device is derived from the amplifier 31.

It will be further appreciatd that in other devices in accordance with the invention any magnetic sensor exhibiting a dipole directional characteristic as aforementioned and to which an alternating biassing magnetic field may be applied may be used instead of the particular kinds of magnetic sensor used in the device described by way of example.

## CLAIMS

1. A device for indicating the direction of an applied magnetic field characterised in that it comprises: first and second magnetic sensors (1, 2) each exhibitng a dipole directional characteristic (13, 15) and disposed with their maximum sensitivity directions at right angles; means (17, 18, 13, 15) for subjecting said sensors (1, 3) to respective sinusoidal biassing magnetic fields in time quadrature relationship so as to produce sensor output signals respectively of the form:

$$\cos \theta \cos wt$$

$$\text{and} \quad \sin \theta \cos (wt \pm \pi/2)$$

where $\theta$ is the angle between the maximum sensitivity direction of one of the sensors (1, 3) and the direction of said applied magnetic field and $\underline{w}$ is the angular frequency of the biassing fields; and means for adding (31) or subtracting (29, 31) said output signals to provide a device output whose phase relative to the phase of said biassing field indicates the direction of said applied magnetic field.

2. A device according to Claim 1 wherein each said sensor (1, 3) comprises at least one member of magnetostrictive material (7) and transducer means (5) responsive to deformation of said magnetostrictive member (7) to produce a said sensor output signal.

3. A device according to Claim 2 wherein said transducer means (5) are made of piezoelectric material.

4. A device according to Claim 3 wherein in each said sensor (1, 7) said member of magnetostrictive material (7) is secured to a first surface of said piezoelectric transducer means (5) and said output of said sensor (1, 3) is derived from between said first surface and a second surface of said piezoelectric transducer means (5) opposite said first surface.

5. A device according to Claim 4 wherein in each said sensor (1, 3) a second member of magnetostrictive materials (7) is secured to said second surface.

6.     A device according to any one of Claims 2 to 5 wherein in each said sensor (1,3) the or each said member of magnetostrictive material (7) and said transducer means (5) are of planar form and secured to one another in parallel relationship.

7.     A device according to any one of Claims 2 to 6 wherein in each said sensor (1, 3) the or each said member of magnetostrictive material (7) consists of an electrically conductive material and serves as an electrode for said sensor (1, 3).

8.     A device according to any one of the preceding claims wherein said means (17, 18, 13, 15) for subjecting said sensors (1, 3) comprises two electric coils (13, 15) each wound around a respective one of said magnetic sensors.

9.     A device according to any one of the preceding claims wherein said sensor output signals are applied to said adding (31) or subtracting (29, 31) means via respective bandpass filters (25).

10.     A device according to any one of Claims 1 to 8 wherein said device output is derived from the output of said adding (31) or subtracting (29, 31) means via a bandpass filter.

Fig.1.

Fig.2.

2/2